# EUROPÄISCHE PATENTSCHRIFT

(11) **EP 4 591 077 B1**
(45) Veröffentlichungstag und Bekanntmachung des Hinweises auf die Patenterteilung: **04.03.2026**
(21) Anmeldenummer: 23775987.3
(22) Anmeldetag: 19.09.2023
(51) Int. Cl.: G01R 31/327, G01R 31/62, G01R 35/00, G05B 19/042, H04L 43/50

(54) **INBETRIEBNAHME EINER PRÜFANORDNUNG**
COMMISSIONING OF A TEST ARRANGEMENT
MISE EN SERVICE D'UN AGENCEMENT DE TEST

(30) Priorität: 21.09.2022 AT 507272022
(43) Veröffentlichungstag der Anmeldung: 30.07.2025
(73) Patentinhaber: Omicron electronics GmbH, 6833 Klaus (AT)
(72) Erfinder: REIN, Florian, 6800 Feldkirch (AT); BLOCHER, Thomas, 6800 Feldkirch (AT)
(74) Vertreter: Patentanwälte Pinter & Weiss OG
(86) Internationale Anmeldenummer: PCT/EP2023/075741
(87) Internationale Veröffentlichungsnummer: WO 2024/061871

(56) Entgegenhaltungen:
- DE-A1- 102004 007 910

## Beschreibung

Die gegenständliche Erfindung betrifft ein Verfahren zur Inbetriebnahme einer Prüfanordnung bestehend aus einer Mehrzahl von Prüfgeräten mit jeweils zumindest einer Prüfkomponente, wobei die Prüfkomponenten der Prüfgeräte zur Durchführung einer Prüfaufgabe über einen Datenbus miteinander verbunden werden. Die Erfindung betrifft auch eine entsprechende Anordnung.

Ein Prüfgerät kann verwendet werden, um an elektrischen Prüfobjekten, wie beispielsweise Stromwandlern, Spannungswandlern, Schutzgeräte und Schutzrelais, Transformatoren, elektrischen Schaltschränken, Elektroverteilern usw., Messungen durchzuführen. Die elektrischen Prüfobjekte sind insbesondere Teile von elektrischen Energieerzeugungs-, Energieübertragung- oder Energieverteilungsanlagen. Zur Durchführung einer Messung ist das Prüfgerät mit dem Prüfobjekt elektrisch zu verbinden. Die Durchführung von Messungen an solchen Prüfobjekten ist potentiell gefährlich, da ein Prüfobjekt eine gefährliche Menge an elektrischer Energie speichern oder führen kann. Daher sind bei der Durchführung von Messungen ausreichende Sicherheitsvorkehrungen zu treffen, um einerseits das Prüfgerät und die Prüfobjekte, aber vor allem auch das Prüfpersonal zu schützen. Aus diesem Grund kann das Prüfgerät durch weitere Prüfkomponenten auf eine Prüfanordnung erweitert werden. Beispielsweise kann ein für das Prüfpersonal gefährlicher Arbeitsbereich mit Warnlampen und Notausschaltern als Prüfkomponenten versehen werden. Notausschalter können eine rasche und sichere Abschaltung eines Strom- und/oder Spannungsverstärkers im Prüfgerät ermöglichen. Warnlampen hingegen können beispielsweise anzeigen, ob das Prüfobjekt bzw. der Arbeitsbereich sicher (stromfrei bzw. entladen) oder unsicher (stromführend) ist. Als weitere Prüfkomponente kann eine Einschaltsicherung des Prüfgeräts vorgesehen sein, um ein unbefugtes Einschalten zu verhindern. Eine Aktivierung einer Einschaltsicherung kann insbesondere bei Arbeiten an der Verkabelung einen wichtigen Sicherheitsaspekt darstellen. Eine Prüfanordnung kann auch mehrere Prüfgeräte umfassen, die miteinander verbunden sein können, beispielsweise über einen Datenbus. Eine Prüfanordnung umfasst somit Prüfgeräte und eine Mehrzahl an Prüfkomponenten, wie Warnlampen, Notausschalter, Einschaltsicherungen, etc. Die Prüfanordnung wird gebildet, indem die Prüfkomponenten durch einen Datenbus miteinander verbunden werden, womit die Prüfkomponenten über eine Datenkommunikation über den Datenbus miteinander kommunizieren können, beispielsweise zur Durchführung einer vorgegebenen Prüfaufgabe. Bei einer solchen Prüfanordnung bestehend aus über einen Datenbus miteinander verbundenen und kommunizierenden Prüfkomponenten ist es, ebenso aus Sicherheitsgründen, wichtig, eine Funktionsprüfung der Prüfanordnung vorzusehen.

Die WO 2021/074373 A1 beschreibt eine solche Prüfanordnung mit einer Funktionsprüfung. Die Komponenten werden dabei in einem Ringbus miteinander verbunden. Ein Busmaster sendet zyklisch ein Datenpaket aus, das von jedem Busteilnehmer (Komponente) weitergeleitet wird. Kommt das Datenpaket wieder beim Busmaster an, kann auf einen geschlossenen, und damit intakten, Ringbus geschlossenen werden. Jeder Busteilnehmer hat einen Bereitschaftsstatus der in Abhängigkeit von einem zyklischen Funktionstest im Busteilnehmer auf aktiv oder inaktiv gesetzt wird. Der Busmaster schickt bei geschlossenem Ringbus ein Bereitschaftssignal an die nächste Komponente. Wenn der Bereitschaftsstatus in dieser Komponente aktiv ist, sendet diese Komponenten das Bereitschaftssignal an die nächste Komponente im Ringbus weiter usw. Wenn der Busmaster das Bereitschaftssignal zurück empfängt, dann wird von einer betriebsbereiten Prüfanordnung ausgegangen. Daraufhin kann die gewünschte Prüfung am Prüfobjekt mit der betriebsbereiten Prüfanordnung ausgeführt werden.

Diese Funktionsprüfung setzt einen verkabelten Ringbus voraus, in dem alle Komponenten, die für die Prüfung des Prüfobjekts und die sichere Durchführung der Prüfung erforderlich sind, vorhanden sind und in den Ringbus eingebunden sind. Es können aber auch bei der Verkabelung Fehler passieren, insbesondere bei größeren Prüfanordnungen mit vielen Komponenten, sodass es vorkommen kann, dass eine Prüfung mit einer Prüfanordnung gestartet oder durchgeführt wird, die nicht der gewünschten oder gar der vorgeschriebenen Konfiguration entspricht. Beispielsweise könnte ein Notausschalter, oder eine Signallampe oder Warnleuchte beim Verkabeln vergessen worden sein. Bei der Durchführung der Prüfung kann das zu gefährlichen Situationen, insbesondere für das Prüfpersonal, führen. Auch eine Beschädigung von Komponenten, insbesondere eines Prüfgeräts, ist damit möglich.

In DE 10 2004 007 910 A1 werden Steuergeräte (Prüfkomponenten) vor Verbau in einem Fahrzeug überprüft. Dabei wird ein Bus-System und eine Prüfeinrichtung verwendet, um die richtige Art und Version der Steuergeräte durch Abfragen zu ermitteln und diese mit einer Soll-Konfigurierung für das Fahrzeug zu vergleichen. Der Soll/Ist-Vergleich wird einem Werker angezeigt.

Es ist damit eine Aufgabe der gegenständlichen Erfindung, die Durchführung einer Prüfung mit einer Prüfanordnung bestehend aus einer Mehrzahl an Prüfkomponenten, die über einen Datenbus miteinander verbunden sind, sicherer zu machen.

Diese Aufgabe wird mit den Merkmalen der unabhängigen Ansprüche gelöst. Vor der Durchführung der Prüfung wird erfindungsgemäß eine Inbetriebnahme ausgeführt, mit der festgestellt wird, ob die tatsächlich vorliegende Prüfanordnung der entspricht, die durch die Prüfaufgabe vorgegebene ist. Nur dann wechselt die Prüfanordnung in einen Betriebsbereitzustand, in dem die Prüfung durchgeführt werden kann. Ansonsten bleibt die Prüfanordnung in einem Nicht-Betriebsbereitzustand, in dem mit der Prüfanordnung keine Prüfung gestartet werden kann. Damit kann die Sicherheit bei der Durchführung einer Prüfung mit einer Prüfanordnung erhöht werden.

Die Prüfanordnung kann einfach in einen Betriebsbereitzustand übergeführt werden, indem das Initiatorgerät in einen Betriebsbereitzustand übergeführt wird. Damit steuert das Prüfgerät, mit dem die Funktionsprüfung durchgeführt wird, selbst, wann die Prüfanordnung in den Betriebsbereitzustand wechselt.

Der Betriebsbereitzustand kann für den Benutzer vorzugsweise angezeigt werden, wenn vom Initiatorgerät eine Anzeigeeinheit aktiviert wird, wenn die Prüfanordnung in einen Betriebsbereitzustand übergeht. Dazu kann eine Anzeigeeinheit am Initiatorgerät aktiviert wird oder eine als Anzeigeeinheit ausgeführte Prüfkomponente eines Prüfgeräts vom Initiatorgerät aktiviert wird.

Wenn die Überprüfung in vorgegebenen Zeitabständen wiederholt wird, indem das Initiatorgerät in vorgegebenen Zeitabständen die Prüfkomponentenliste neu bestimmt und den Vergleich der gespeicherten Benutzerkonfigurationsliste mit jeder neu bestimmten Prüfkomponentenliste durchführt und die Prüfanordnung im Betriebsbereitzustand bleibt, wenn die gespeicherte Benutzerkonfigurationsliste der neuen Prüfkomponentenliste entspricht und ansonsten in einem Nicht-Betriebsbereitzustand wechselt, kann die Sicherheit der Prüfanordnung auch während des Betriebs der Prüfanordnung verbessert werden. Die Benutzerkonfigurationsliste ist hierbei die gespeicherte, letzte durch den Benutzer bestätigte Prüfkomponentenliste. Kommt es während der Durchführung der Prüfaufgabe mit der Prüfanordnung zu einem Fehler, der zu einer fehlerhaften Konfiguration der Prüfanordnung führt, kann das erkannt werden und die Prüfanordnung in einen Nicht-Betriebsbereitzustand überführt werden.

Die gegenständliche Erfindung wird nachfolgend unter Bezugnahme auf die Figuren 1 bis 5 näher erläutert, die beispielhaft, schematisch und nicht einschränkend vorteilhafte Ausgestaltungen der Erfindung zeigen. Dabei zeigt
Fig.1 die Verwendung einer Prüfanordnung zur Durchführung einer Prüfaufgabe an einem Prüfobjekt,
Fig.2 ein Prüfgerät mit mehreren Prüfkomponenten,
Fig.3 eine Anordnung zur Durchführung der Funktionsüberprüfung einer Prüfanordnung,
Fig.4 ein Prüfgerät mit einer Funktionsüberprüfungseinheit und
Fig.5 eine Prüfanordnung mit mehreren Prüfgeräten mit Funktionsüberprüfungseinheit.

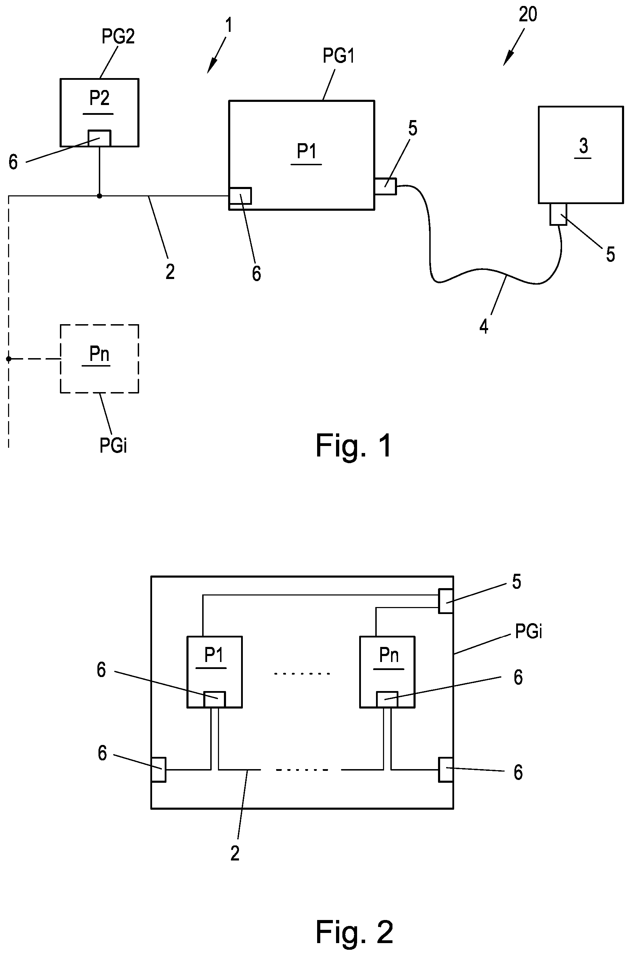

Fig.1 zeigt eine Ausgestaltung einer Prüfanordnung 1 bestehend aus zwei Prüfgeräten PGi mit jeweils zumindest einer Prüfkomponente Pn. i und n dienen hierbei als Index zur Unterscheidung der verschiedenen Prüfgeräte PGi und Prüfkomponenten Pn. Wenn der jeweilige Teil allgemein angesprochen werden, wird "PGi" oder "Pn" verwendet, ansonsten werden die Prüfgeräte und Prüfkomponenten über den jeweiligen Index unterschieden. Allgemein gilt n ≥ i.

Die Prüfanordnung 1 umfasst eine Mehrzahl i>1 von Prüfgeräten PGi, wobei jedes Prüfgerät PGi zumindest eine Prüfkomponente Pn umfasst. Die Prüfkomponenten Pn sind über einen Datenbus 2 miteinander verbunden, beispielsweise über ein Datenkabel miteinander verkabelt. Der Datenbus 2 sorgt dafür, dass jede Prüfkomponente Pn über den Datenbus 2 mit jeder anderen Prüfkomponente Pn mittels einer Datenübertragung über den Datenbus 2 kommunizieren kann.

Der Datenbus 2 kann kabelgebunden oder kabellos ausgeführt sein. Auch eine Mischform mit einem teilweise kabellosen und teilweise kabelgebundenen Datenbus 2 ist denkbar. Vorzugsweise ist der gesamte Datenbus 2 der Prüfanordnung 1 kabelgebunden. Im Falle eines zumindest teilweise kabelgebundenen Datenbusses 2 sind zumindest zwei Prüfkomponenten Pn über ein Datenkabel miteinander verkabelt, wodurch der Datenbus 2 zwischen diesen Prüfkomponenten Pn ausgebildet wird. Im Falle eines zumindest teilweise kabellosen Datenbusses 2 sind zumindest zwei Prüfkomponenten Pn über eine kabellose Datenkommunikationsstrecke, beispielsweise Funk, WLAN, Bluetooth usw., miteinander gekoppelt.

Die Bustopologie des durch die Verbindung der Prüfkomponenten Pn entstehenden Datenbusses 2 spielt für die Erfindung keine Rolle. Der Datenbus 2 kann beispielsweise als Ringbus, Linienbus, Sternbus, Maschenbus, Baumbus usw. vorliegen. Das für die Datenübertragung implementierte Datenkommunikationsprotokoll spielt für die Erfindung ebenso keine Rolle. Ebenso ist es unerheblich, ob über den Datenbus 2 eine bidirektionale oder unidirektionale Datenübertagung möglich ist.

Eine Prüfkomponente Pn hat damit zumindest eine Datenbus-Datenschnittstelle 6 zum Datenbus 2, über die die Prüfkomponente Pn mit zumindest einer anderen Prüfkomponente Pn über den Datenbus 2 verbunden werden kann. Die Datenbus-Datenschnittstelle 6 ermöglicht die Datenübertragung der Prüfkomponente Pn über den verbundenen Datenbus 2.

Eine Prüfkomponente Pn kann beispielsweise eine Warnlampe, Signalleuchte, akustischer Signalgeber, Notausschalter, Einschaltsicherung usw. sein, aber auch ein Stromverstärker zur Erzeugung eines elektrischen Stromes an einem Stromausgang oder ein Spannungsverstärker zur Erzeugung einer elektrischen Spannung an einem Spannungsausgang.

Es ist auch denkbar, dass mehrere Prüfkomponenten Pn in einem Prüfgerät PGi integriert sind, wie in Fig.2 dargestellt. Beispielsweise können in einem Prüfgerät PGi mehrere Stromverstärker und/oder Spannungsverstärker als Prüfkomponenten Pn verbaut sein, gegebenenfalls auch mit weiteren Prüfkomponenten Pn, wie Notausschalter oder Signalleuchten. Sind mehrere Prüfkomponenten Pn in einem Prüfgerät PGi integriert, so sind diese Prüfkomponenten Pn im Prüfgerät PGi bereits über einen Datenbus 2 miteinander verbunden, vorzugsweise verdrahtet, wie beispielsweise in Fig.2 dargestellt. Auch ein solches Prüfgerät PGi kann mit einem weiteren Prüfgerät PGi mit jeweils zumindest einer Prüfkomponenten Pn zu einer Prüfanordnung 1 verbunden werden. Hierzu weist das Prüfgerät PGi zumindest eine Datenbus-Datenschnittstelle 6 auf, mit der das Prüfgerät PGi, konkret die im Prüfgerät PGi über einen Datenbus 2 miteinander verbundenen Prüfkomponenten Pn, mit einem anderen Prüfgerät PGi über den Datenbus 2 verbunden werden kann.

Für die Durchführung einer Prüfaufgabe mit der Prüfanordnung 1 wird zumindest eine Prüfkomponente Pn der Prüfanordnung 1 elektrisch mit einem Prüfobjekt 3 verbunden, beispielsweise mittels eines Prüfkabels 4, wie in der Ausgestaltung der Fig.1. Am Prüfkabel 4, sowie am Prüfobjekt 3 und/oder an der Prüfkomponente Pn können hierfür auch geeignete Kontakte 5, wie beispielsweise eine Steckverbindung, vorgesehen sein. In einer Konfiguration eines Prüfgeräts PGi mit mehreren Prüfkomponenten Pn ist es auch möglich, mehrere Prüfkomponenten Pn über ein gemeinsames Prüfkabel 4 mit einem Prüfobjekt 3 zu verbinden. Hierzu kann ein mehrpoliger Kontakt 5 und ein mehrpoliges Prüfkabel 4 vorgesehen sein, wie in Fig.2 angedeutet.

Das Prüfobjekt 3, und gegebenenfalls ein Prüfkabel 4, sind aber nicht Teil der Prüfanordnung 1, sondern bilden eine Testanordnung 20 mit einer Prüfanordnung 1 und einem Prüfobjekt 3 aus, die miteinander elektrisch verbunden sind.

Als Prüfobjekt 3 kommt jegliches elektrisches Gerät in Frage. Ein Prüfobjekt 3 ist beispielsweise eine elektrische Komponente einer Anlage zur Erzeugung, Übertragung oder Verteilung von elektrischer Energie, z.B. ein elektrisches Versorgungsnetz. Solche Komponenten sind beispielsweise Sicherheitseinrichtungen, wie Schutzgeräte, Schutzrelais, Wiedereinschaltvorrichtungen, Leistungsschalter oder Trennschalter, oder Messeinrichtungen, wie Stromwandler oder Spannungswandler, oder elektrische Spannungswandler, wie Transformatoren, Stromrichter usw., Geräte zur Erzeugung elektrischer Energie, wie Generatoren usw., oder ein elektrischer Verteiler mit Sicherungselementen und/oder Schaltelementen. Diese Aufzählung ist nur beispielhaft und nicht abschließend. In welcher Weise und womit das Prüfobjekt 3 und eine Prüfkomponente Pn elektrisch verbunden wird, hängt natürlich vom Prüfobjekt 3 aber auch von der Art der Prüfaufgabe ab.

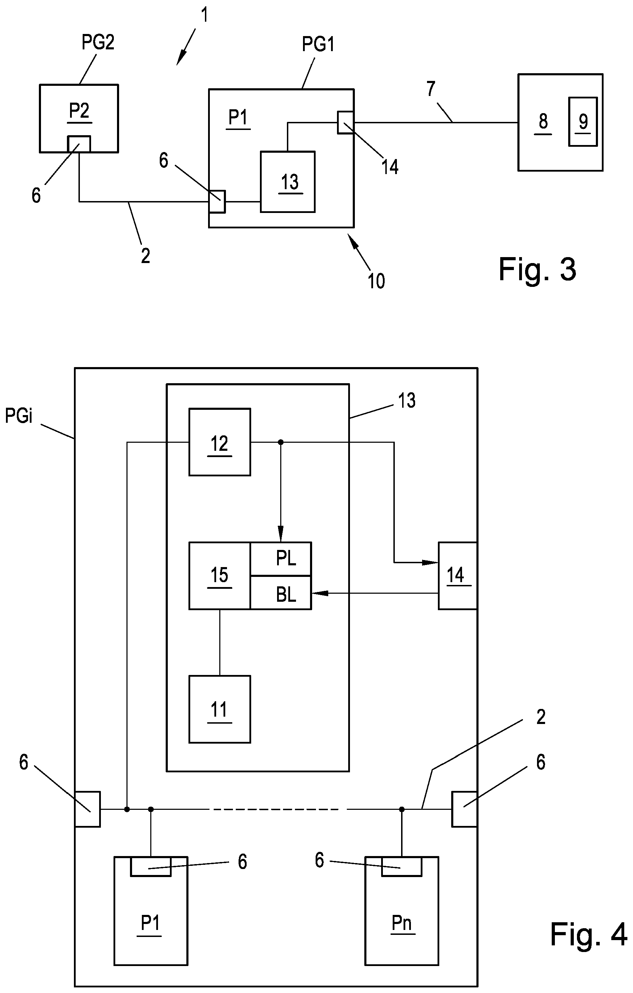

Aus Sicherheitsgründen ist die Prüfanordnung 1 zur Inbetriebnahme, also vor der Durchführung einer Prüfaufgabe, einer Funktionsprüfung zu Unterziehen. Die Prüfanordnung 1 soll nur dann in einen Betriebsbereitzustand übergeführt werden, wenn die Funktionsprüfung erfolgreich abgeschlossen wurde. Ansonsten soll die Prüfanordnung 1 in einem nicht betriebsbereiten Zustand verbleiben, in dem die Prüfanordnung 1 nicht in Betrieb genommen werden kann. Die Erfindung betrifft ein Verfahren zur Inbetriebnahme der Prüfanordnung 1, mit der ein Aspekt der Funktionsfähigkeit der Prüfanordnung 1 geprüft wird und das mit Bezugnahme auf die Fig.3 und 4 erläutert wird. Daneben können an der Prüfanordnung 1 auch noch weitere Funktionsprüfungen durchgeführt werden, beispielsweise wie in der WO 2021/074373 A1 beschrieben.

Der erste Schritt des Verfahrens ist die Verbindung, beispielsweise Verkabelung oder Einrichtung der kabellosen Verbindung, der Prüfkomponenten Pn, sofern erforderlich. Das erfolgt nach einer vorgegebenen Prüfkonfiguration der an der Prüfaufgabe beteiligten Prüfkomponenten Pn, die die Prüfanordnung 1 bilden. Die Prüfkonfiguration kann in Form einer Konfigurationsliste mit allen beteiligten Prüfkomponenten Pn vorliegen. Die Verbindung erfolgt durch Prüfpersonal, das die Prüfaufgabe mit der Prüfanordnung 1 durchführen soll.

Die Prüfkonfiguration enthält zumindest eine Auflistung aller an der Prüfanordnung 1 beteiligten Prüfkomponententypen, beispielsweise Stromverstärker, Spannungsverstärker, Warnleuchten, Notausschalter usw.

Durch die Verbindung entsteht der Datenbus 2, der die Prüfkomponenten Pn der Prüfanordnung 1 miteinander verbindet. Die Prüfkonfiguration ist durch die durchzuführende Prüfaufgabe vorgegeben, und legt insbesondere fest, welche Prüfkomponenten Pn für die Durchführung der Prüfaufgabe in der Prüfanordnung 1 vorhanden sein müssen. Beispielsweise kann zumindest ein Prüfgerät PG1 mit zumindest einer Prüfkomponente P1 in Form eines Strom- oder Spannungsverstärkers und zumindest ein weiteres Prüfgerät PG2 mit einer Warnleuchte als Prüfkomponente P2 vorgegeben sein, wie in Fig.3 dargestellt.

Es ist auch möglich, dass durch die Prüfkonfiguration nicht nur die vorzusehenden Prüfkomponenten Pn vorgegeben sind, sondern auch eine bestimmte Reihenfolge der Verbindung der Prüfgeräte PGi oder Prüfkomponenten Pn.

Als nächster Schritt des Verfahrens wird zumindest ein Prüfgerät PGi mit einer Funktionsüberprüfungseinheit 13 als Initiatorgerät 10 festgelegt, in Fig.3 beispielsweise das Prüfgerät PG1. In der Funktionsüberprüfungseinheit 13 sind weitere Funktionalitäten zur Durchführung des erfindungsgemäßen Verfahrens implementiert, wie nachfolgend im Detail ausgeführt wird. Es muss nicht in jedem Prüfgerät PGi eine Funktionsüberprüfungseinheit 13 implementiert sein, aber es muss in der Prüfanordnung 1 zumindest ein Prüfgerät PGi mit einer Funktionsüberprüfungseinheit 13 geben, und damit zumindest ein Prüfgerät PGi, das als Initiatorgerät 10 fungieren kann.

Die Funktionsüberprüfungseinheit 13 umfasst zumindest eine Speichereinheit 15, eine Vergleichereinheit 11 und eine Busdetektionseinheit 12. Hierfür kann im Prüfgerät PGi mit der Funktionsüberprüfungseinheit 13 eine mikroprozessorbasierte Hardware, wie ein Mikrocontroller, vorgesehen sein, auf der bestimmte Funktionalitäten, wie beispielsweise die der Vergleichereinheit 11 und/oder der Busdetektionseinheit 12, als auf der mikroprozessorbasierten Hardware ablaufenden Software ausgeführt sind. Die Speichereinheit 15 kann ein Speicherbaustein sein oder ein Speicher der mikroprozessorbasierten Hardware. Die Funktionsüberprüfungseinheit 13, oder bestimmte Funktionalitäten davon, können auch auf einer eigenständigen Steuereinheit eines Prüfgerät PGi implementiert sein, beispielsweise als Software. Auf einer Steuereinheit eines Prüfgeräts PGi läuft beispielsweise Firmware des Prüfgeräts PGi, mit der Funktionen des Prüfgeräts PGi durchgeführt werden.

Zur Durchführung der Funktionsprüfung wird das Initiatorgerät 10 mit einer Überprüfungseinheit 8 verbunden. Hierfür ist am Initiatorgerät 10 eine geeignete Datenschnittstelle 14 vorgesehen, über die die Überprüfungseinheit 8 über eine Datenverbindung 7 an das Initiatorgerät 10 angeschlossen wird. Die Datenschnittstelle 14 ist beispielsweise ein USB-Port oder eine drahtlose Schnittstelle, wie Bluetooth oder WLAN.

Die Überprüfungseinheit 8 wirkt mit der damit verbundenen Funktionsüberprüfungseinheit 13 im Initiatorgerät 10 zur Durchführung der Funktionsprüfung zusammen.

Die Überprüfungseinheit 8 ist vorzugsweise eine mikroprozessorbasierte Hardware, beispielsweise ein Mikrokontroller, ein Computer, ein mobiles Gerät oder ein mobiles Endgerät, auf der entsprechende Software zur Durchführung der Funktionsüberprüfung in Zusammenwirkung mit der Funktionsüberprüfungseinheit 13 abläuft.

Als nächster Schritt des erfindungsgemäßen Verfahrens bestimmt das Initiatorgerät 10, konkret die Busdetektionseinheit 12 der Funktionsüberprüfungseinheit 13 des Initiatorgeräts 10, alle am Datenbus 2 angeschlossenen Prüfkomponenten Pn. Die Busdetektionseinheit 12 ist hierfür mit dem Datenbus 2 verbunden.

Die Bestimmung aller am Datenbus 2 angeschlossener Prüfgeräte PGi kann auf verschiedenste Weisen erfolgen. Beispielsweise kann das Initiatorgerät 10 über den Datenbus 2 eine Busnachricht an alle Prüfkomponenten Pn senden, mit der Aufforderung zur Übermittlung einer Anwesenheitsnachricht. Die Prüfkomponenten Pn übermitteln daraufhin jeweils eine Anwesenheitsnachricht an das Initiatorgerät 10, womit alle Prüfkomponenten Pn feststellbar sind. Es wäre auch denkbar, dass alle Prüfkomponenten Pn in regelmäßigen Abständen Anwesenheitsnachrichten über den Datenbus 2 senden, die vom Initiatorgerät 10 gelesen werden. Daneben gibt es natürlich auch noch weitere Möglichkeiten zur Bestimmung aller am Datenbus 2 vorhandener Prüfkomponenten Pn.

In einer Anwesenheitsnachricht wird zumindest der Prüfkomponententyp übermittelt, also die Information um welche Art von Gerät es sich handelt, beispielsweise um einen Stromverstärker, Spannungsverstärker, Warnleuchte, Signalleuchte, Notausschalter usw. Zusätzlich kann auch eine eindeutige Identifikation der jeweiligen Prüfkomponente Pn, eine Position im Datenbus 2, eine SW- oder HW-Versionsnummer, oder andere Information übermittelt werden.

Alle am Datenbus 2 angeschlossenen Prüfkomponenten Pn werden in einer Prüfkomponentenliste PL im Initiatorgerät 10, konkret in der Speichereinheit 15 der Funktionsüberprüfungseinheit 13, gespeichert.

Die Prüfkomponentenliste PL umfasst zumindest eine Auflistung der Prüfkomponententypen aller am Datenbus 2 erreichbaren Prüfkomponenten Pn. Es ist damit möglich, dass es in der Prüfkomponentenliste PL mehrere Einträge eines bestimmten Prüfkomponententyps gibt.

Die ermittelte Prüfkomponentenliste PL wird in einem nächsten Verfahrensschritt über die Datenschnittstelle 14 an die an das Initiatorgerät 10 angeschlossene Überprüfungseinheit 8 gesendet.

Als nächster Verfahrensschritt wird die an die Überprüfungseinheit 8 übermittelte Prüfkomponentenliste PL an der Überprüfungseinheit 8 für einen Benutzer angezeigt werden. Das Format, wie die Prüfkomponentenliste PL angezeigt wird, ist hierbei unwesentlich, solange die vorhandenen Prüfkomponententypen durch den Benutzer feststellbar sind.

Hierzu kann an der Überprüfungseinheit 8 eine Benutzerschnittstelle 9 vorgesehen sein, beispielsweise eine visuelle und/oder akustische Anzeige.

Damit kann der Benutzer die an der Überprüfungseinheit 8 angezeigte Prüfkomponentenliste PL prüfen, insbesondere die vom Initiatorgerät 10 erhaltene Prüfkomponentenliste PL mit der vorgegebenen Prüfkonfiguration vergleichen.

Wenn die erhaltene Prüfkomponentenliste PL der vorgegebenen Prüfkonfiguration entspricht, bestätigt der Benutzer die Prüfkomponentenliste PL, beispielsweise über ein Eingabegerät der Benutzerschnittstelle 9. Die Überprüfungseinheit 8 sendet daraufhin die bestätigte Prüfkomponentenliste PL als Benutzerkonfigurationsliste BL an das Initiatorgerät 10.

Im Initiatorgerät 10 wird die gespeicherte Prüfkomponentenliste PL mit der von der Überprüfungseinheit 8 erhaltenen Benutzerkonfigurationsliste BL verglichen. Das erfolgt in der Vergleichereinheit 11 der Funktionsüberprüfungseinheit 13, die hierzu auch mit der Speichereinheit 15 verbunden ist. Der Vergleich umfasst damit zumindest die Feststellung, ob die Prüfkomponententypen und die Anzahl der Prüfkomponententypen in der Prüfkomponentenliste PL und der Benutzerkonfigurationsliste BL übereinstimmen.

Wenn die Übereinstimmung festgestellt wird, dann wird die Prüfanordnung 1 in einen Betriebsbereitzustand übergeführt. Das kann erfolgen, indem das Initiatorgerät 10 in einen Betriebsbereitzustand übergeführt wird. Im Betriebsbereitzustand der Prüfanordnung 1 kann die vorgesehene Prüfaufgabe mit der Prüfanordnung 1 ausgeführt werden.

Wenn die gespeicherte Prüfkomponentenliste PL mit der von der Überprüfungseinheit 8 erhaltenen Benutzerkonfigurationsliste BL nicht übereinstimmt, dann verharrt die Prüfanordnung 1, bzw. das Initiatorgerät 10, in einem nicht Betriebsbereitzustand und die Prüfanordnung 1 kann nicht in Betrieb genommen werden.

Um den Betriebsbereitzustand für den Benutzer anzuzeigen, kann dieser vom Initiatorgerät 10 an einer Anzeigeeinheit angezeigt werden. Die Anzeigeeinheit kann Teil des Initiatorgeräts 10 sein, beispielsweise eine Signalleuchte am Initiatorgerät 10 oder eine akustische Signalausgabe. Es kann aber auch vorgesehen sein, eine Prüfkomponente Pn als Anzeigeeinheit vorzusehen. Die Prüfkomponente Pn kann hierfür beispielsweise als Signalleuchte oder akustische Ausgabeeinheit ausgeführt sein. Das Initiatorgerät 10 kann in diesem Fall der Prüfkomponente Pn über den Datenbus 2 eine Datennachricht senden, um die Prüfkomponente Pn zur Aktivierung der Anzeigeeinheit zu veranlassen.

Die von der Überprüfungseinheit 8 an das Initiatorgerät 10 gesendete Benutzerkonfigurationsliste BL kann auch im Initiatorgerät 10 gespeichert bleiben, beispielsweise in der Speichereinheit 15. Das ermöglicht es, die Überprüfung der Prüfanordnung 1 in vorgegebenen Zeitabständen zu wiederholen. Das Initiatorgerät 10 wiederholt die Ermittlung der Prüfkomponentenliste PL in vorgegebenen Zeitabständen und überprüft die dabei festgestellte Prüfkomponentenliste PL jeweils mit der gespeicherten Benutzerkonfigurationsliste BL. Im Normalfall sollte sich die Prüfkomponentenliste PL nicht ändern, sodass die Prüfanordnung 1 im Betriebsbereitzustand bleibt. Kommt es jedoch aufgrund eines Fehlers, wie beispielsweise ein Kabelbruch eines Datenkabels des Datenbusses 2 oder aufgrund eines Fehlers in einer Prüfkomponente Pn, zu einer Abweichung zwischen der erneut ermittelten Prüfkomponentenliste PL und der gespeicherten Benutzerkonfigurationsliste BL, dann wird die Prüfanordnung 1 in den nicht Betriebsbereitzustand übergeführt. Eine dabei allfällig laufende Prüfaufgabe wird dabei unterbrochen.

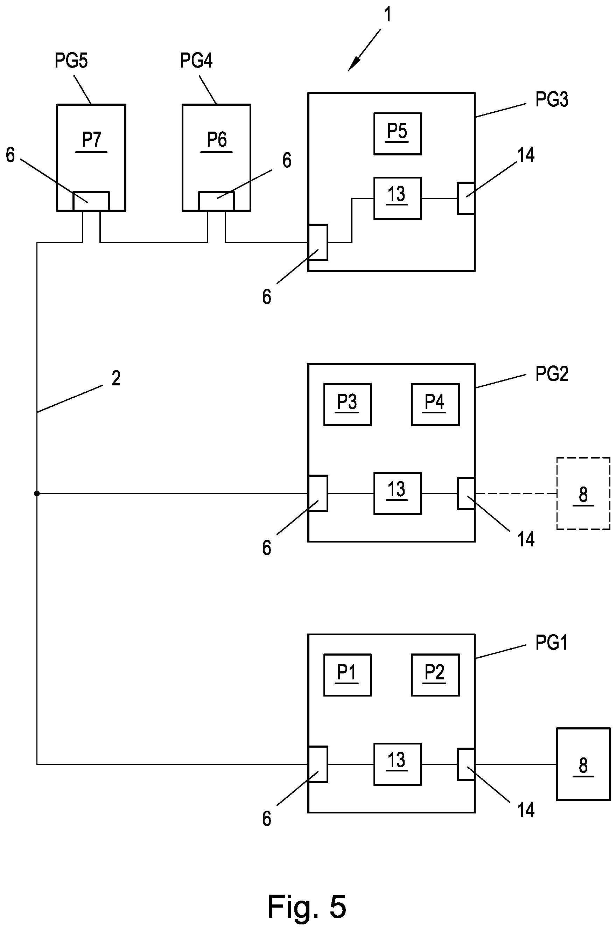

Es kann auch vorgesehen sein, dass in einer Prüfanordnung 1 mehrere Prüfgeräte PGi mit einer Funktionsüberprüfungseinheit 13 vorhanden sind, beispielsweise wie in Fig.5 dargestellt. In diesem Fall kann die oben beschriebene Prozedur an mehreren oder auch an jedem Prüfgeräte PGi mit einer Funktionsüberprüfungseinheit 13 ausgeführt werden, wie in Fig.5 gestrichelt angedeutet. Es muss daher in dieser Ausführung jedes Prüfgeräte PGi mit einer Funktionsüberprüfungseinheit 13 in einen Betriebsbereitzustand übergeführt werden, um die Prüfanordnung 1 einsetzen zu können.

Durch das erfindungsgemäße Verfahren kann gewährleistet werden, dass eine Prüfanordnung 1 nur dann in den Betriebsbereitzustand wechselt, wenn die tatsächliche Konfiguration der Prüfanordnung 1 (Prüfkomponentenliste PL) mit der vorgegebenen Prüfkonfiguration übereinstimmt. Der Benutzer der Prüfanordnung 1 kann das auf einfache und sichere Weise feststellen.

Ein Prüfgerät PGi mit einer Funktionsüberprüfungseinheit 13 kann beispielsweise mit einer werksseitig vorkonfigurierten Benutzerkonfigurationsliste BL ausgeliefert werden. Um ein solches Prüfgerät PGi in einer bestimmten Prüfanordnung 1 verwenden zu können, muss die vorkonfigurierte Benutzerkonfigurationsliste BL zuerst gemäß den Vorgaben der mit der Prüfanordnung 1 durchzuführenden Prüfaufgabe (vorgegebene Prüfkonfiguration) aktualisiert werden. Das erfindungsgemäße Verfahren ermöglicht auch ein sicheres Vorgehen zur Aktualisierung der Benutzerkonfigurationsliste BL.

## Patentansprüche

1. Verfahren zur Inbetriebnahme einer Prüfanordnung (1) bestehend aus einer Mehrzahl i von Prüfgeräten (PGi) mit jeweils zumindest einer Prüfkomponente (Pn), wobei die Prüfkomponenten (Pn) der Prüfgeräte (PGi) zur Durchführung einer Prüfaufgabe über einen Datenbus (2) miteinander verbunden werden, wobei das Verfahren die folgenden Schritte umfasst
- Verbinden der Prüfkomponenten (Pn) der Prüfgeräte (PGi) nach einer vorgegebenen Prüfkonfiguration der an der Prüfaufgabe beteiligten Prüfkomponenten (Pn),
- Festlegen zumindest eines Prüfgeräts (PGi) mit einer Funktionsüberprüfungseinheit (13) als Initiatorgerät (10),
- Bestimmen aller am Datenbus (2) angeschlossenen Prüfkomponenten (Pn) durch die Funktionsüberprüfungseinheit (13) des zumindest einen Initiatorgeräts (10) und Speichern aller am Datenbus (2) angeschlossenen Prüfkomponenten (Pn) in einer Prüfkomponentenliste (PL) im Initiatorgerät (10),
- Übermitteln der Prüfkomponentenliste (PL) an eine mit dem Initiatorgerät (10) verbundene Überprüfungseinheit (8),
- Anzeigen der übermittelten Prüfkomponentenliste (PL) an der Überprüfungseinheit (8),
- Prüfen der an der Überprüfungseinheit (8) angezeigten Prüfkomponentenliste (PL) durch einen Benutzer,
- Bestätigen der an der Überprüfungseinheit (8) angezeigten Prüfkomponentenliste (PL) durch den Benutzer an der Überprüfungseinheit (8), wenn diese der vorgegebenen Prüfkonfiguration entspricht und Übermitteln der angezeigten Prüfkomponentenliste (PL) als Benutzerkonfigurationsliste (BL) von der Überprüfungseinheit (8) an das Initiatorgerät (10),
- Vergleichen der von der Überprüfungseinheit (8) erhaltenen Benutzerkonfigurationsliste (BL) und der im Initiatorgerät (10) gespeicherten Prüfkomponentenliste (PL) im Initiatorgerät (10),
- Überführen der Prüfanordnung (1) in einen Betriebsbereitzustand, wenn die erhaltene Benutzerkonfigurationsliste (BL) der gespeicherten Prüfkomponentenliste (PL) entspricht.

2. Verfahren nach Anspruch 1, **dadurch gekennzeichnet, dass** die Prüfanordnung (1) in einen Betriebsbereitzustand übergeführt wird, indem das Initiatorgerät (10) in einen Betriebsbereitzustand übergeführt wird.

3. Verfahren nach Anspruch 1 oder 2, **dadurch gekennzeichnet, dass** vom Initiatorgerät (10) eine Anzeigeeinheit aktiviert wird, wenn die Prüfanordnung (1) in einen Betriebsbereitzustand übergeht.

4. Verfahren nach Anspruch 3, **dadurch gekennzeichnet, dass** eine Anzeigeeinheit am Initiatorgerät (10) aktiviert wird oder eine als Anzeigeeinheit ausgeführte Prüfkomponente (Pn) eines Prüfgeräts (PGi) vom Initiatorgerät (10) aktiviert wird.

5. Verfahren nach Anspruch 1, **dadurch gekennzeichnet, dass** die von der Überprüfungseinheit (8) erhaltene Benutzerkonfigurationsliste (BL) im Initiatorgerät (10) gespeichert wird, **dass** das Initiatorgerät (10) in vorgegebenen Zeitabständen die Prüfkomponentenliste (PL) neu bestimmt und den Vergleich der gespeicherten Benutzerkonfigurationsliste (BL) mit jeder neu bestimmten Prüfkomponentenliste (PL) durchführt **und dass** die Prüfanordnung (1) im Betriebsbereitzustand bleibt, wenn die gespeicherte Benutzerkonfigurationsliste (BL) der neuen Prüfkomponentenliste (PL) entspricht und ansonsten in einem Nicht-Betriebsbereitzustand wechselt.

6. Anordnung zur Inbetriebnahme einer Prüfanordnung (1) bestehend aus einer Mehrzahl i von Prüfgeräten (PGi) mit jeweils zumindest einer Prüfkomponente, wobei die Prüfkomponenten (Pn) der Prüfgeräte (PGi) zur Durchführung einer Prüfaufgabe nach einer vorgegebenen Prüfkonfiguration der an der Prüfaufgabe beteiligten Prüfkomponenten (Pn) über einen Datenbus (2) miteinander verbunden sind, **dadurch gekennzeichnet, dass** in einem Prüfgerät (PGi) eine Funktionsüberprüfungseinheit (13) vorgesehen ist und dieses Prüfgerät (PGi) als Initiatorgerät (10) festgelegt ist, **dass** im Initiatorgerät (10) eine Busdetektionseinheit (12) der Funktionsüberprüfungseinheit (13) vorgesehen ist, die eingerichtet ist, alle am Datenbus (2) angeschlossenen Prüfkomponenten (Pn) zu ermitteln, **dass** im Initiatorgerät (10) eine Speichereinheit (15) der Funktionsüberprüfungseinheit (13) vorgesehen ist, die eingerichtet ist, die ermittelten Prüfkomponenten (Pn) in einer Prüfkomponentenliste (PL) zu speichern, **dass** das Initiatorgerät (10) mit einer Überprüfungseinheit (8) verbunden ist und das Initiatorgerät (10) die gespeicherte Prüfkomponentenliste (PL) an die verbundenen Überprüfungseinheit (8) übermittelt und die Überprüfungseinheit (8) eingerichtet ist, die übermittelte Prüfkomponentenliste (PL) an einer Benutzerschnittstelle (9) anzuzeigen, **dass** ein Benutzer die an der Überprüfungseinheit (8) angezeigte Prüfkomponentenliste (PL) überprüft und der Benutzer die an der Überprüfungseinheit (8) angezeigten Prüfkomponentenliste (PL) an der Benutzerschnittstelle (9) bestätigt, wenn diese der vorgegebenen Prüfkonfiguration entspricht, **dass** die Überprüfungseinheit (8) eingerichtet ist, die angezeigte Prüfkomponentenliste (PL) als Benutzerkonfigurationsliste (BL) an das Initiatorgerät (10) zu übermittelt, dass im Initiatorgerät (10) eine Vergleichereinheit (11) der Funktionsüberprüfungseinheit (13) vorgesehen ist, die eingerichtet ist, die von der Überprüfungseinheit (8) erhaltenen Benutzerkonfigurationsliste (BL) und die im Initiatorgerät (10) gespeicherte Prüfkomponentenliste (PL) zu vergleichen, **und dass** vorgesehen ist, dass die Prüfanordnung (1) in einen Betriebsbereitzustand wechselt, wenn die erhaltene Benutzerkonfigurationsliste (BL) der gespeicherten Prüfkomponentenliste (PL) entspricht.

7. Anordnung nach Anspruch 6, **dadurch gekennzeichnet, dass** die Prüfanordnung (1) in einen Betriebsbereitzustand wechselt, indem das Initiatorgerät (10) in einen Betriebsbereitzustand wechselt.

8. Anordnung nach Anspruch 6, **dadurch gekennzeichnet, dass** die Speichereinheit (15) eingerichtet ist, die von der Überprüfungseinheit (8) erhaltene Benutzerkonfigurationsliste (BL) im Initiatorgerät (10) speichern, **dass** die Busdetektionseinheit (12) eingerichtet ist, die Prüfkomponentenliste (PL) in vorgegebenen Zeitabständen neu zu bestimmen und die Vergleichereinheit (11) eingerichtet ist, den Vergleich der gespeicherten Benutzerkonfigurationsliste (BL) mit jeder neu bestimmten Prüfkomponentenliste (PL) durchzuführen **und dass** die Prüfanordnung (1) im Betriebsbereitzustand bleibt, wenn die gespeicherte Benutzerkonfigurationsliste (BL) der neuen Prüfkomponentenliste (PL) entspricht und ansonsten in einem Nicht-Betriebsbereitzustand wechselt.

## Claims

1. A method for commissioning a test arrangement (1) consisting of a plurality i of test devices (PGi) each having at least one test component (Pn), wherein the test components (Pn) of the test devices (PGi) are connected to one another via a data bus (2) for carrying out a test task, wherein the method comprises the following steps
- connecting the test components (Pn) of the test devices (PGi) according to a predefined test configuration of the test components (Pn) involved in the test task,
- determining at least one test device (PGi) with a function check unit (13) as initiator device (10),
- determining all test components (Pn) connected to the data bus (2) by the function check unit (13) of the at least one initiator device (10) and storage of all test components (Pn) connected to the data bus (2) in a test component list (PL) in the initiator device (10),
- transmitting the test component list (PL) to a verification unit (8) connected to the initiator device (10),
- displaying the transmitted test component list (PL) on the verification unit (8),
- checking the test component list (PL) displayed on the verification unit (8) by a user,
- confirming the test component list (PL) displayed on the verification unit (8) by the user on the verification unit (8) if it corresponds to the specified test configuration and transmitting the displayed test component list (PL) as a user configuration list (BL) from the verification unit (8) to the initiator device (10),
- comparing the user configuration list (BL) received from the verification unit (8) and the test component list (PL) stored in the initiator device (10) in the initiator device (10),
- transferring the test arrangement (1) to a ready-for-operation state if the received user configuration list (BL) corresponds to the stored test component list (PL).

2. The method according to claim 1, **characterized in that** the test arrangement (1) is transferred to a ready-for-operation state by transferring the initiator device (10) to a ready-for-operation state.

3. The method according to claim 1 or 2, **characterized in that** a display unit is activated by the initiator device (10) when the test arrangement (1) enters a ready-for-operation state.

4. The method according to claim 3, **characterized in that** a display unit on the initiator device (10) is activated or a test component (Pn) of a test device (PGi) designed as a display unit is activated by the initiator device (10).

5. The method according to claim 1, **characterized in that** the user configuration list (BL) obtained from the verification unit (8) is stored in the initiator device (10), **in that** the initiator device (10) redetermines the test component list (PL) at predetermined intervals and carries out the comparison of the stored user configuration list (BL) with each newly determined test component list (PL) **and in that** the test arrangement (1) remains in the ready-for-operation state if the stored user configuration list (BL) corresponds to the new test component list (PL) and otherwise changes to a non-ready-for-operation state.

6. An arrangement for commissioning a test arrangement (1) consisting of a plurality i of test devices (PGi) each having at least one test component, wherein the test components (Pn) of the test devices (PGi) are connected to one another via a data bus (2) for carrying out a test task in accordance with a predetermined test configuration of the test components (Pn) involved in the test task, **characterized in that** a function check unit (13) is provided in a test device (PGi) and this test device (PGi) is defined as an initiator device (10), **in that** a bus detection unit (12) of the function check unit (13) is provided in the initiator device (10), which is set up to determine all test components (Pn) connected to the data bus (2), **in that** a storage unit (15) of the function check unit (13) is provided in the initiator device (10), which is set up to store the determined test components (Pn) in a test component list (PL), **in that** the initiator device (10) is connected to a verification unit (8) and the initiator device (10) transmits the stored test component list (PL) to the connected verification unit (8) and the verification unit (8) is set up to display the transmitted test component list (PL) on a user interface (9), **in that** a user checks the test component list (PL) displayed on the verification unit (8) and the user confirms the test component list (PL) displayed on the verification unit (8) at the user interface (9) if it corresponds to the specified test configuration, **in that** the verification unit (8) is set up to transmit the displayed test component list (PL) to the initiator device (10) as a user configuration list (BL), **in that** a comparator unit (11) of the function check unit (13) is provided in the initiator device (10), which is set up to compare the user configuration list (BL) received from the verification unit (8) and the test component list (PL) stored in the initiator device (10), **and in that** it is provided that the test arrangement (1) changes to a ready-for-operation state when the received user configuration list (BL) corresponds to the stored test component list (PL).

7. The arrangement according to claim 6, **characterized in that** the test arrangement (1) changes to a ready-for-operation state by the initiator device (10) changing to a ready-for-operation state.

8. The arrangement according to claim 6, **characterized in that** the storage unit (15) is set up to store the user configuration list (BL) received from the verification unit (8) in the initiator device (10), **in that** the bus detection unit (12) is set up to redetermine the test component list (PL) at predetermined time intervals and the comparator unit (11) is set up to carry out the comparison of the stored user configuration list (BL) with each redetermined test component list (PL) **and in that** the test arrangement (1) remains in the ready-for-operation state if the stored user configuration list (BL) corresponds to the new test component list (PL) and otherwise changes to a non-ready-for-operation state.

## Revendications

1. Procédé de mise en service d'un agencement de test (1) constitué d'une pluralité i d'appareils de test (PGi) comportant respectivement au moins un composant de test (Pn), dans lequel les composants de test (Pn) des appareils de test (PGi) sont reliés entre eux par l'intermédiaire d'un bus de données (2) pour la réalisation d'une tâche de test, dans lequel le procédé comprend les étapes suivantes
- liaison des composants de test (Pn) des appareils de test (PGi) selon une configuration de test prédéfinie des composants de test (Pn) impliqués dans la tâche de test,
- définition d'au moins un appareil de test (PGi) comportant une unité de vérification de fonctionnement (13) comme appareil initiateur (10),
- détermination de tous les composants de test (Pn) raccordés au bus de données (2) par l'unité de vérification de fonctionnement (13) de l'au moins un appareil initiateur (10) et stockage de tous les composants de test (Pn) raccordés au bus de données (2) dans une liste de composants de test (PL) dans l'appareil initiateur (10),
- transmission de la liste des composants de test (PL) à une unité de vérification (8) reliée à l'appareil initiateur (10),
- affichage de la liste des composants de test (PL) transmise sur l'unité de vérification (8),
- test par un utilisateur de la liste des composants de test (PL) affichée sur l'unité de vérification (8),
- confirmation de la liste de composants de test (PL) affichée sur l'unité de vérification (8) par l'utilisateur sur l'unité de vérification (8), si celle-ci correspond à la configuration de test prédéfinie et transmission de la liste de composants de test (PL) affichée en tant que liste de configuration utilisateur (BL) de l'unité de vérification (8) à l'appareil initiateur (10),
- comparaison de la liste de configuration utilisateur (BL) obtenue par l'unité de vérification (8) et la liste de composants de test (PL) stockée dans l'appareil initiateur (10) dans l'appareil initiateur (10),
- placement de l'agencement de test (1) dans un état prêt à fonctionner lorsque la liste de configuration utilisateur (BL) obtenue correspond à la liste de composants de test (PL) stockée.

2. Procédé selon la revendication 1, **caractérisé en ce que** l'agencement de test (1) est placé dans un état prêt à fonctionner en plaçant l'appareil initiateur (10) dans un état prêt à fonctionner.

3. Procédé selon la revendication 1 ou 2, **caractérisé en ce qu'**une unité d'affichage est activée par l'appareil initiateur (10) lorsque l'agencement de test (1) est placé dans un état prêt à fonctionner.

4. Procédé selon la revendication 3, **caractérisé en ce qu'**une unité d'affichage est activée sur l'appareil initiateur (10) ou qu'un composant de test (Pn) d'un appareil de test (PGi) conçu comme unité d'affichage est activé par l'appareil initiateur (10).

5. Procédé selon la revendication 1, **caractérisé en ce que** la liste de configuration utilisateur (BL) obtenue par l'unité de vérification (8) est stockée dans l'appareil initiateur (10), **en ce que** l'appareil initiateur (10) détermine de nouveau la liste de composants de test (PL) à des intervalles de temps prédéfinis et réalise la comparaison de la liste de configuration utilisateur (BL) stockée avec chaque liste de composants de test (PL) nouvellement déterminée **et en ce que** l'agencement de test (1) reste dans un état prêt à fonctionner si la liste de configuration utilisateur (BL) stockée correspond à la nouvelle liste de composants de test (PL) et passe dans un état non prêt à fonctionner dans le cas contraire.

6. Agencement pour la mise en service d'un agencement de test (1) constitué d'une pluralité i d'appareils de test (PGi) comportant respectivement au moins un composant de test, dans lequel les composants de test (Pn) des appareils de test (PGi) sont reliés entre eux par l'intermédiaire d'un bus de données (2) pour la réalisation d'une tâche de test selon une configuration de test prédéfinie des composants de test (Pn) impliqués dans la tâche de test, **caractérisé en ce qu'**une unité de vérification de fonctionnement (13) est prévue dans un appareil de test (PGi) et cet appareil de test (PGi) est défini comme appareil initiateur (10), **en ce qu'**il est prévu dans l'appareil initiateur (10) une unité de détection de bus (12) de l'unité de vérification de fonctionnement (13), qui est mise en œuvre pour déterminer tous les composants de test (Pn) raccordés au bus de données (2), **en ce qu'**il est prévu dans l'appareil initiateur (10) une unité de stockage (15) de l'unité de vérification de fonctionnement (13), qui est mise en œuvre pour stocker les composants de test (Pn) déterminés dans une liste de composants de test (PL), **en ce que** l'appareil initiateur (10) est relié à une unité de vérification (8) et l'appareil initiateur (10) transmet la liste de composants de test (PL) stockée à l'unité de vérification (8) reliée et l'unité de vérification (8) est mise en œuvre pour afficher la liste de composants de test (PL) transmise sur une interface utilisateur (9), **en ce qu'**un utilisateur vérifie la liste de composants de test (PL) affichée sur l'unité de vérification (8) et l'utilisateur confirme la liste de composants de test (PL) affichée sur l'unité de vérification (8) sur l'interface utilisateur (9) si celle-ci correspond à la configuration de test prédéfinie, **en ce que** l'unité de vérification (8) est mise en œuvre pour transmettre la liste de composants de test (PL) affichée en tant que liste de configuration utilisateur (BL) à l'appareil initiateur (10), **en ce qu'**il est prévu dans l'appareil initiateur (10) une unité de comparaison (11) de l'unité de vérification de fonctionnement (13) qui est mise en œuvre pour comparer la liste de configuration utilisateur (BL) obtenue par l'unité de vérification (8) et la liste de composants de test (PL) stockée dans l'appareil initiateur (10), **et en ce qu'**il est prévu que l'agencement de test (1) passe à un état prêt à fonctionner lorsque la liste de configuration d'utilisateur (BL) obtenue correspond à la liste de composants de test (PL) stockée.

7. Agencement selon la revendication 6, **caractérisé en ce que** l'agencement de test (1) passe à un état prêt à fonctionner en faisant passer l'appareil initiateur (10) à un état prêt à fonctionner.

8. Agencement selon la revendication 6, **caractérisé en ce que** l'unité de stockage (15) est mise en œuvre pour stocker la liste de configuration utilisateur (BL) obtenue par l'unité de vérification (8) dans l'appareil initiateur (10), **en ce que** l'unité de détection de bus (12) est mise en œuvre pour déterminer de nouveau la liste de composants de test (PL) à des intervalles de temps prédéfinis et l'unité de comparaison (11) est mise en œuvre pour réaliser la comparaison de la liste de configuration utilisateur (BL) stockée avec chaque liste de composants de test (PL) nouvellement déterminée **et en ce que** l'agencement de test (1) reste dans l'état prêt à fonctionner si la liste de configuration utilisateur (BL) stockée correspond à la nouvelle liste de composants de test (PL) et passe dans un état non prêt à fonctionner dans le cas contraire.
